# EUROPEAN PATENT SPECIFICATION

(11) **EP 1 674 905 B1**
(45) Date of publication and mention of the grant of the patent: **15.10.2008**
(21) Application number: 05257943.0
(22) Date of filing: 21.12.2005
(51) Int. Cl.: G02B 6/138

(54) **Methods of forming optical devices having polymeric layers**
Verfahren zur Herstellung optischer Vorrichtungen mit Polymerschichten
Procédés de formation de dispositifs optiques avec couches polymériques

(30) Priority: 22.12.2004 US 638458 P
(43) Date of publication of application: 28.06.2006
(73) Proprietor: Rohm and Haas Electronic Materials, L.L.C., Marlborough, Massachusetts 01752 (US)
(72) Inventor: Shelnut, James G., Lancaster, Massachusetts 01523 (US); Moynihan, Matthew L., Sterling, Massachusetts 01564 (US); Little, Luke W., Brighton, Massachusetts 02135 (US)
(74) Representative: Kent, Venetia Katherine

(56) References cited:
- EP-A- 1 251 155
- US-A1- 2003 091 926
- BHATTACHARYA S K ET AL: "Integral passives for next generation of electronic packaging: application of epoxy/ceramic nanocomposites as integral capacitors" MICROELECTRONICS JOURNAL, MACKINTOSH PUBLICATIONS LTD. LUTON, GB, vol. 32, no. 1, January 2001 (2001-01), pages 11-19, XP004219945 ISSN: 0026-2692
- BOOTH B L: "LOW LOSS CHANNEL WAVEGUIDES IN POLYMERS" JOURNAL OF LIGHTWAVE TECHNOLOGY, IEEE SERVICE CENTER, NEW YORK, NY, US, vol. 7, no. 10, 1 October 1989 (1989-10-01), pages 1445-1453, XP000113351 ISSN: 0733-8724

## Description

### BACKGROUND OF THE INVENTION

The present invention relates generally to the field of optoelectronics. In particular, the present invention relates to methods of forming optical devices, such as optical waveguides, using a combination of dry-film and liquid coating techniques. In addition, the present invention relates to methods of forming printed circuit boards having optical functionality.

Signal transmission using pulse sequences of light is becoming increasingly important in highspeed communications and data transfer. For example, optical integrated circuits are gaining importance for high bandwidth optical interconnects. As a result, the integration of optical components such as waveguides, filters, optical interconnects, lenses, diffraction gratings, and the like, is becoming increasingly important

The incorporation of optical layers in the form of embedded optical waveguides into printed circuit boards is known. For example, U.S. Patent No. 6,731,857 and U.S. Published Application No. US20040105652 to Shelnut et al. disclose embedded optical waveguides formed with silsesquioxane chemistry on a printed circuit board substrate. The optical waveguides include a core and a clad surrounding the core, with optical radiation propagating in the core due to its higher index of refraction as compared to the clad.

Bhattacharya S K et al, "Integral passives for next generation of electronic packaging: application of epoxy/ceramic nanocomposites as integral capacitors", Microelectronics Journal, MacKintosh Publications Ltd. Luton, GB vol. 32, no. 1, Jan. 2001 (2001-01), pp. 11-19, XP004219945 ISSN:0026-2692, discloses materials and processes for integral capacitors and their co-integration with integral resistors and inductors. A schematic diagram is provided of a single layer integrated module (SLIM) which includes optical waveguides.

EP-A-1 251 155 discloses photodefinable silisesquioxane compositions for use in forming optical waveguides. The compositions include a silsesquioxane oligomer including as polymerized units a monomer of the formula (RSiO1.5), wherein R is selected from hydroxyphenyl or hydroxybenzyl, and a photoactive component, wherein the solubility of the silsesquioxane oligomer is altered upon exposure to actinic radiation. The compositions are typically first disposed as a layer on a substrate by any means including, but not limited to, screen coating (or screen printing), curtain coating, roller coating, slot coating, spin coating, flood coating, electrostatic spray, spray coating, dip coating or as a dry film.

Booth B L, "Low Loss Channel Waveguides in Polymers", Journal of Lightwave Technology, IEEE Service Center, New York, NY, US, vol. 7, no. 10, 1 October 1989 (1989-10-10), pp. 1445-1453, XP000113351 ISSN: 0733-8724, discloses a method of forming a polymeric channel waveguide which involves exposure of a light sensitive polymeric layer followed by lamination of buffer layers to each side of the waveguide layer to create a three-layer sandwich.

Embedded optical waveguides may be formed by coating a bottom clad layer over the substrate, coating a core layer over the bottom clad layer, patterning the core layer to form a core structure, and forming a top clad layer over the bottom clad layer and core structure. The bottom clad layer, core layer and top clad layer are each typically formed from a composition in liquid form which may be applied by a variety of coating techniques, such as roller coating, curtain coating, spin-coating and the like.

Formation of optical waveguides on a printed circuit board using a series of pre-cast layers has also been proposed. For example, International Publication No. WO 03/005616 discloses methods of forming multi-level printed circuit boards that integrate optical data communications with other boards without electrical connections. The entire top surface of the printed circuit board is laminated with a first polymeric optical conductive layer. A second, higher refractive index polymer having the same properties as the first layer is laminated on the entire top surface area of the first layer. The layers are channeled by laser ablation to create a void down to the underlying copper layer. An additional layer of the first layer polymer material is laminated over the top polymer layer, filling in the laser-created channels to form optical waveguides.

The use of pre-cast optical layers in place of liquid chemicals in circuit board manufacturing presents various benefits to the manufacturer, such as elimination of waste handling problems associated with solvent-based liquid chemicals. Difficulties may, however, be encountered in laminating pre-cast layers. For example, the surface of the printed circuit board may contain structures such as copper traces, rendering it non-planar and thus difficult to laminate thereon an optical layer such as a waveguide bottom clad layer. Further, in laminating a waveguide top clad layer over a bottom clad layer and core structure, elimination of air pockets between the cores and second clad is desired to minimize optical loss. This can prove difficult as the bottom clad and cores do not provide a planar surface for lamination of the top clad layer. Similarly, a laminated second clad layer would be expected to exhibit a non-planar topography similar to the bottom clad/core surface to which it is laminated. A non-planar surface would generally not be desired where additional structures are to be formed over the surface of the waveguide top clad layer.

There is thus a need in the art for methods of forming optical components and methods of forming printed circuit boards which overcome or conspicuously ameliorate one or more of the foregoing problems associated with the state of the art.

### SUMMARY OF THE INVENTION

One aspect of the invention provides a method of forming an optical device as specified in claim 1.

In accordance with a further aspect of the invention, provided is a method as specified in claim 9.

Other objects and advantages of the present invention will become apparent to one skilled in the art upon review of the following description, claims, and drawings appended hereto.

### BRIEF DESCRIPTION OF THE DRAWINGS

The present invention will be discussed with reference to the following drawings, in which like reference numerals denote like features, and in which:
FIG. 1A-C illustrates exemplary optical dry-films in accordance with the invention; and
FIG. 2A-F illustrates a printed circuit board having optical functionality at various stages of formation thereof in accordance with the invention.

### DETAILED DESCRIPTION OF THE INVENTION

The present invention provides methods of forming an optical component using a combination of dry-film and wet chemistry techniques. Briefly stated, the methods involve applying over a first substrate a dry-film which includes a carrier substrate and a first polymeric layer over the carrier substrate. Prior to or after application of the dry-film, a second polymeric layer is formed over the first substrate by coating a liquid composition. The first polymeric layer may include units of the formula (R¹SiO_{1.5}), wherein R¹ is a substituted or unsubstituted organic group, and the liquid composition may include units of the formula (R²SiO_{1.5}), wherein R² is a substituted or unsubstituted organic group, and R¹ and R² may be the same or different.

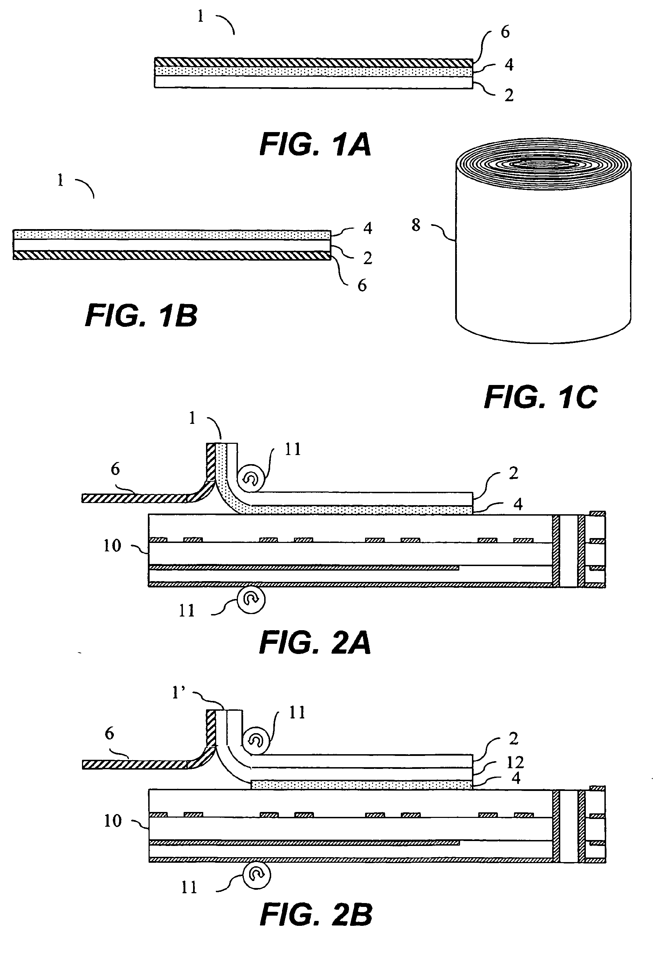

The present invention will now be described with reference to FIG. 1, which illustrates in cross-section an exemplary dry-film 1 useful in the methods of the present invention. The illustrated dry-film 1 includes a carrier substrate 2, a polymeric layer 4 over the carrier substrate, and an optional protective cover layer 6. The protective cover layer 6 may, for example, be disposed on the frontside of the dry-film over the polymeric layer 6 as shown in FIG. 1A or on the backside of the dry-film as illustrated in FIG. 1B. Use of a backside protective cover layer may be desired, for example, where multiple dry-film sheets are arranged in a stacked arrangement or if the dry-film is stored in roll-form 8 such as shown in FIG. 1C.

The carrier substrate 2 functions as a mechanical support for the polymeric layer 4 and any other layers of the dry-film. The carrier substrate 2 may be removed from the remainder of the dry-film in subsequent use, or may form part of the final structure of the device fabricated. Where the carrier substrate is eventually removed from the dry-film such as by peeling, adhesion between the carrier substrate and the remainder of the dry-film is sufficiently low to allow for ease in separation from the remainder of the dry-film. In cases in which the carrier substrate is to form part of the final device, adhesion is typically high to prevent peeling from the carrier substrate. The particular material used for the carrier substrate may vary widely. The material may be natural or synthetic and may be capable of existing in a flexible or rigid film/sheet form. Suitable carrier substrate materials include, for example: polyethylene terephthalate (PET), typically an optically pure PET, which may be treated in various ways, for example, resin-coated, flame or electrostatic discharge-treated, or slip-treated; a paper such as polyvinyl alcohol-coated paper, crosslinked polyester-coated paper, polyethylene-coated paper, cellulose paper, or a heavy paper such as lithographic paper; nylon; glass; cellulose acetate; a synthetic organic resin; a polyolefin such as polypropylene; a polyimide; a polyurethane; a polyacrylate such as polymethylmethacrylate (PMMA); fiberboard; a metal such as copper, aluminum, tin, magnesium, zinc, nickel, or an alloy thereof; and a multilayered structure of two or more of these or other materials, for example, a copper-coated fiberboard or epoxy laminate. The carrier substrate typically has a thickness, for example, of from about 25 to 250 µm.

The polymeric layer 4 is of a material making it suitable for use in forming an optical component, for example, an optical waveguide, a filter, an optical interconnect, a lens, a diffraction grating, and the like. In the case of an optical waveguide, for example, the polymeric layer may be used in forming the waveguide core and/or clad. The polymeric layer may be formed from a composition that includes silsesquioxane units of the formula (R¹SiO_{1.5}), wherein R¹ is a substituted or unsubstituted organic group, together with additional and optional components. Such material may be photoimageable or non-photoimageable. Details of such compositions useful in forming the polymeric layer 4 are provided below. The thickness of the polymeric layer 4 is typically from about 5 to 150 µm.

The protective cover layer 6 provides protection to the polymeric layer 4, and is typically in the form of a removable film/sheet that may be peeled from the remainder of the dry-film. In general, any material may be used that can withstand the process conditions and allows for easy removal. Adhesion of the protective cover layer 6 to the polymeric film 4 is typically less than that of the carrier substrate to the polymeric layer 4 to allow for its separation from the remainder of the dry-film without also causing separation of the carrier substrate. Suitable materials for the protective cover layer include, for example, polyolefins such as polyethylene and polypropylene, polyvinyl alcohol, and PET. The protective cover layer may be coated with a release layer which allows for easy separation from the remainder of the dry-film. Suitable release layer materials include, for example, thermally or photochemically cured silicones, polyvinyl stearate, polyvinyl carbamates, poly N-ethyl-perfluoroactyl sulfanamidoethyl methacrylate, poly (tetrafluorothylene), polypropylene, polymethyl methacrylate, polysiloxanes, polyamides,and other release materials such as those described in Satas, Handbook of Pressure Sensitive Adhesive Technology, 2nd ed., Van Nostrand/Reinhold (1989). The protective cover layer 6 typically has a thickness of from about 10 to 100 µm.

FIG. 2A-F illustrates an optical waveguide structure on a printed circuit board at various stages of formation thereof. While the invention is described with reference to this exemplary embodiment, it should be clear that optical components other than waveguides may be formed, such as filters, optical interconnects, lenses, and diffraction gratings. Similarly, electronic substrates other than printed circuit board substrates, such as semiconductor wafers, and non-electronic substrates may be employed.

As shown in FIG. 2A, a printed circuit board substrate 10 is provided. The printed circuit board substrate may be, for example, a laminated sheet that includes a series of epoxy resin and copper layers, on which etched electronic circuits, conductive traces and electronic components are formed or will be formed on one or both sides. Depending on the board's design, the optical waveguide structure may be incorporated into the board at an earlier or later stage in the board fabrication process.

The dry-film 1 described above is affixed to the printed circuit board substrate 10 to form an optical waveguide bottom clad layer. Suitable techniques for affixing the dry-film to the substrate 10 include, for example, lamination such as hot roll lamination. In the exemplified method, the dry-film 1 is placed into a hot roll laminator, the protective cover layer 6 is peeled away from the polymeric layer 4, and the polymeric layer 4 is brought into contact with and laminated to the printed circuit board substrate 10 using rollers 11 with heat and pressure. The lamination temperature is typically from about 21 to 150°C, for example, from about 25 to 110°C. The pressure is typically from about 0.1 to 5 kg/cm², for example, from about 0.3 to 2 kg/cm². The speed of the rollers 11 is typically from about 1.5 to 600 cm/min, for example, from about 30 to 150 cm/min. After lamination, the carrier substrate 2 may be removed from the polymeric layer 4 and printed circuit board substrate 10, typically by peeling. The polymeric layer 4 may next be cured by thermal treatment in the case of a thermally curable composition. Typical curing temperatures are from about 120 to 200°C, for example, from about 145 to 180°C, and curing time is typically from about 0.5 to 5 hours, for example, from about 1 to 3 hours. The polymeric layer 4 may optionally be a photoimageable material, in which case it may be treated by blanket or through-mask exposure to actinic radiation followed by a thermal cure and optional development.

With reference to FIG. 2B, a waveguide core dry-film 1' is next affixed to the bottom clad layer 4 in the manner described above with reference to the bottom clad dry-film 1. The core dry-film 1' may have the same or similar construction as the bottom clad dry-film 1, except the polymeric layer 12 in the core dry-film should provide a refractive index in the final waveguide structure that is greater than that of the clad. As with the polymeric layer 4, the polymeric layer 12 may be photoimageable or non-photoimageable.

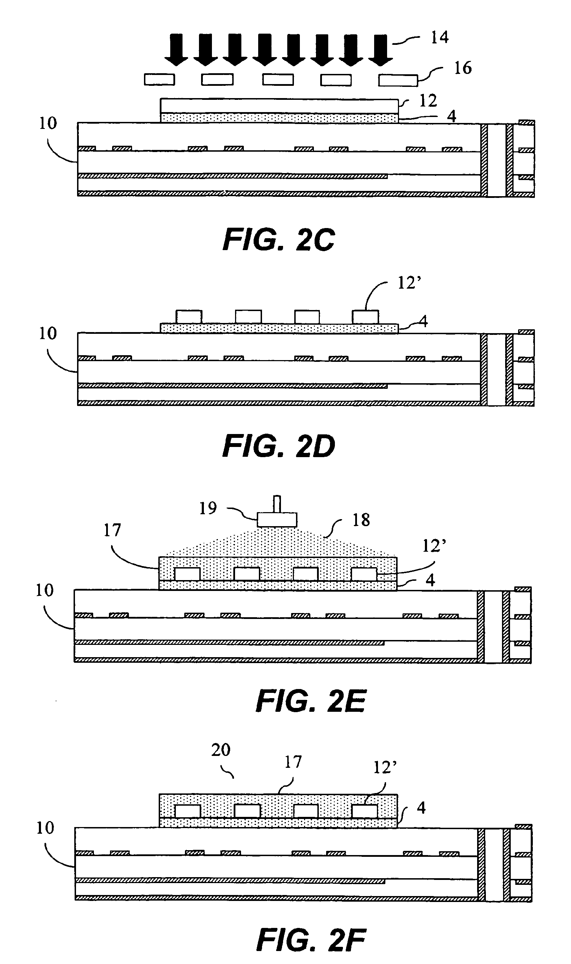

The second polymeric layer 12 is next patterned as illustrated in FIG. 2C and D. In the case of a photoimageable core material, core layer 12 is imaged, for example, by exposure to actinic radiation 14 through a photomask 16, as illustrated in FIG. 2C. As shown in FIG. 2D, in the case of a negative-working material, the unexposed portions of core layer 12 are developed away, leaving one or more core structures 12'. In the case of a non-photoimageable material, the core layer 12 may be patterned through other techniques, for example, using laser ablation or imprint lithography techniques.

Following formation of core structures 12', a top clad layer 17 is formed over the bottom clad layer 4 and core structures 12' by a liquid coating technique, as shown in FIG. 2E. The liquid-coated material allows for planarization of the waveguide in a simple manner. The polymer layer forming the top clad may be the same material described below used in forming the polymeric layer of the dry film. The liquid composition 18 is coated over the first clad 4 and core structures 12' through a coating device 19, for example, a spray coater. A waveguide structure 20 including bottom clad layer 4, core structure 12' and top clad layer 17 is thereby formed, as shown in FIG. 2F. By use of a liquid composition in forming the top clad layer, the non-planar bottom clad/core surface may be completely covered without air pockets between the core and top clad layer. As well, a planar upper surface of the waveguide structure may be achieved.

Following formation of the optical waveguide structure on the printed circuit board substrate 10, the printed circuit board may be further processed. For example, one or more dielectric and/or metal layers may be formed over the waveguide structure, to form a metallization structure for signal routing. Electrically connecting an optoelectronic device such as a photodetector or a laser emitting device, for example, a VCSEL chip, may also be performed at this stage. The printed circuit board is processed to completion using known techniques such as those described in Coombs, Printed Circuit Handbook, 5th ed., McGraw-Hill (2001).

While the illustrated embodiment includes a dry-film for each of the bottom clad and core layers, and a liquid coating composition for the top clad layer, it should be clear that such method is merely exemplary and other combinations may be employed. For example, in forming an optical waveguide, the bottom clad layer or core layer alone, or the bottom clad layer and top clad layer may be formed from a liquid composition, while a dry-film is used for the other layer(s). Further, while not used in the illustrated embodiment, the bottom clad and/or top clad layer may be photoimageable, in which case they may be treated by blanket exposure to actinic radiation followed by a thermal cure or patterned as described above with reference to the core structure.

As described above, the dry-film polymeric layer and the polymeric layer resulting from the liquid chemistry may each be formed from a composition that includes silsesquioxane units of the formula (RSiO_{1.5}), wherein R is the same or different for the dry-film and wet chemistry compositions. The polymer may be present in the composition in an amount of from 1 to 99.5 wt%, for example from 60 to 98.5 wt%. Exemplary organic groups for R include substituted and unsubstituted alkyl, aryl and heterocyclic groups. The alkyl groups may be straight chain, branched or cyclic having, for example, from 1 to 20 carbon atoms, and typically have from 1 to 20 carbon atoms, such as methyl, ethyl, propyl, isopropyl, t-butyl, t-amyl, octyl, decyl, dodecyl, cetyl, stearyl, cyclohexyl, and 2-ethylhexyl. The alkyl groups may be substituted with heteroatoms in and/or on the alkyl chain, for example, or may be non-aromatic cyclic groups such as cyclopentyl, cyclohexyl, norbonyl, adamantly, piperidinyl, tetrahydrofuranyl and tetrahydrothiophenyl groups. Exemplary aryl groups include those having from 6 to 20 carbon atoms, for example, from 6 to 15 carbon atoms, such as phenyl, tolyl, benzyl, 1-naphthyl, 2-naphthyl and 2-phenanthryl, and may be substituted with heteroatoms, for example hydroxy and/or amino. Heterocyclic groups may be aromatic, for example, thiophene, pyridine, pyrimidine, pyrrole, phosphole, arsole, and furane. Typical for R is a substituted and unsubstituted methyl, ethyl, propyl, cyclopentyl, cyclohexyl, benzyl, phenyl, adamantyl groups, and combinations thereof.

The polymer may take the form of a copolymer or higher order polymer, either random- or block-type. The polymer may include, for example, one or more additional silicon-containing units, with the proportions for each unit ranging from 1 to 85 wt%, for example, from 15 to 80 wt% or from 25 to 60 wt%, or from 25 to 50 wt%, based on the polymer. The additional units may, for example, be represented as silsesquioxanes, cage siloxanes, siloxanes and combinations thereof. For example, the polymer may further include units of the formula (R¹SiO_{1.5}), wherein R¹ is a substituted or unsubstituted organic group as described above with respect to R. One of R and R¹ may, for example, be chosen from substituted or unsubstituted alkyl groups, and the other of R and R¹ chosen from substituted or unsubstituted aryl groups. The polymer may be, for example, an alkyl silicon polymer such as a copolymer containing methyl silsesquioxane units and butyl silsesquioxane units; an aryl silicon polymer such as a copolymer containing phenyl silsesquioxane units and trifluoromethylphenyl-silsesquioxane units or an aralkyl silicon copolymer such as a copolymer containing methyl and phenyl silsesquioxane units.

Suitable siloxanes include, for example, units of the formula ((R²)₂SiO), wherein R² is a substituted or unsubstituted organic group, such as an alkyl group, for example, methyl, ethyl, propyl, and the like, or an aryl group, for example, phenyl, tolyl, and the like.

As described above, the side chain groups of the polymer may be optionally substituted. "Substituted" means that one or more hydrogen atoms on one or more side chain groups are replaced by another substituent group, for example, deuterium, halogen such as fluorine, bromine, and chlorine, (C₁-C₆)alkyl, (C₁-C₆)haloalkyl, (C₁-C₁₀)alkoxy, (C₁-C₁₀)alkylcarbonyl, (C₁-C₁₀)alkoxycarbonyl, (C₁-C₁₀)alkylcarbonyloxy, alkylamine, alkylsulfur containing materials, and the like. The polymers may contain a wide range of repeating units. Thus, the polymer may vary widely in molecular weight. Typically, the polymers have a weight average molecular weight (M_{w}) of from about 500 to 15,000, more typically from about 1000 to 10,000.

The polymers may include two or more functional end groups that allow a solubility change in the composition after photoactivation. Such end groups may be, for example, hydroxy; alkoxy such as ethoxy, propoxy, isopropoxy; carboxyester, amino, amido, epoxy, imino, carboxyacid, anhydride, olefinic, acrylic, acetal, orthoester, vinyl ether, and combinations thereof. The functional end content may be, for example, from about 0.5 to 35 wt% based on the polymer.

The polymeric layers formed from the compositions may be photoimageable and include a component for altering the solubility of the layers upon photoactivation. The photoactive component alters the solubility of the layers in a dried state in a developer. The photoactive component typically generates an acid or base upon activation. A wide variety of photoactive components may be used in the present invention, including, but not limited to, photoacid generators and photobase generators.

The photoacid generators useful in the present invention may be any compound or compounds which generate acid upon exposure to light. Suitable photoacid generators are known and include, but are not limited to, halogenated triazines, onium salts, sulfonated esters, substituted hydroxyimides, substituted hydroxylimines, azides, naphthoquinones such as diazonaphthoquinones, diazo compounds, and combinations thereof.

Useful halogenated triazines include, for example, halogenated alkyl triazines such as the trihalomethyl-s-triazines. The s-triazine compounds are condensation reaction products of certain methyl-trihalomethyl-s-triazines and certain aldehydes or aldehyde derivatives. Such s-triazine compounds may be prepared according to the procedures disclosed in U.S. Pat. No. 3,954,475 and Wakabayashi et al., Bulletin of the Chemical Society of Japan, 42, 2924-30 (1969). Other triazine type photoacid generators useful in the present invention are disclosed, for example, in U.S. Patent. No. 5,366,846.

Onium salts with weakly nucleophilic anions are particularly suitable for use as photoacid generators in the present invention. Examples of such anions are the halogen complex anions of divalent to heptavalent metals or non-metals, for example, antimony, tin, iron, bismuth, aluminum, gallium, indium, titanium, zirconium, scandium, chromium, hafnium, copper, boron, phosphorus and arsenic. Examples of suitable onium salts include, but are not limited to, diazonium salts such as diaryl-diazonium salts and onium salts of group VA and B, IIA and B and I of the Periodic Table, for example, halonium salts such as iodonium salts, quaternary ammonium, phosphonium and arsonium salts, sulfonium salts such as aromatic sulfonium salts, sulfoxonium salts or selenium salts. Examples of suitable onium salts are disclosed, for example, in U.S. Patent Nos. 4,442,197; 4,603,101; and 4,624,912. Sulfonium salts such as triphenylsulfonium hexafluorophosphate and mixtures thereof are typical.

The sulfonated esters useful as photoacid generators in the present invention include, for example, sulfonyloxy ketones. Suitable sulfonated esters include, but are not limited to, benzoin tosylate, t-butylphenyl alpha-(p-toluenesulfonyloxy)-acetate, 2,6-dinitrobenzyl tosylate, and t-butyl alpha-(p-toluenesulfonyloxy)-acetate. Such sulfonated esters are disclosed, for example, in the Journal of Photopolymer Science and Technology, vol. 4, No. 3,337-340 (1991).

Substituted hydroxyimides which may be used include, for example, n-trifluoromethylsulfonyloxy-2,3-diphenylmaleimide and 2-trifluoromethylbenzenesulfonyloxy-2,3-diphenylmaleimide. Suitable substituted hydroxylimines include, for example, 2-(-nitrilo-2-methylbenzylidene)-(5-hydroxyiminobutylsulfonyl)-thiophene. Azides useful in the present invention include, for example, 2,6-(4-azidobenzylidene)cyclohexanone. Naphthoquinones may include, for example, 2,1-diazonaphthoquinone-4-sulfonate ester of 2,3,4-trihydroxybenzophenone. Among the diazo compounds, 1,7-bis(4-chlorosulonyl phenyl)-4-diazo-3,5-heptanedione may be used.

Photobase generators useful in the present invention may be any compound or compounds which liberate base upon exposure to light. Suitable photobase generators include, but are not limited to, benzyl carbamates, benzoin carbamates, O-carbamoylhydroxyamines, O-carbamoyloximes, aromatic sulfonamides, alpha-lactams, N-(2-allylethenyl)amides, arylazide compounds, N-arylformamides, 4-(ortho-nitrophenyl)dihydropyridines, and combinations thereof.

The amount of photoactive component, in the case of a negative working material, is any amount sufficient to alter the solubility of the polymeric layer upon exposure to actinic radiation and render the exposed portion insoluble in a developer. The photoactive component is typically present in the composition in an amount of from 0.1 to 25 wt%, for example from 0.1 to 12 wt%.

The developer for a photoimageable waveguide core and/or clad may be an aqueous or non-aqueous developer solution, or a combination thereof, and may optionally include one or more additives, for example, antifoaming agents, surfactants and the like. Typical aqueous developers include, for example, alkali metal hydroxides such as sodium hydroxide and potassium hydroxide in water, as well as tetraalkylammonium hydroxide such as tetramethylammonium hydroxide, in water. Such developers are typically used in concentrations from 0.1 to 2N, for example, 0.15 to 1N, or 0.26 to 0.7N.

Typical non-aqueous developers include, for example, ketones, for example acetone, methyl ethyl ketone, methyl isobutyl ketone, cyclohexanone, 2-octanone, 2-heptanone and methyl isoamyl ketone; alcohols such as ethanol, isopropanol, n-propanol, n-butanol, isobutanol and benzyl alcohol; esters such as ethyl acetate, ethyl propionate and ethyl lactate; glycol ethers such as ethylene glycol methyl ether, propylene glycol ethyl ether, propylene glycol methyl ether; glycol ether esters such as ethylene glycol monomethyl ether acetate and propylene glycol mono methyl ether acetate; aromatics such as toluene, xylene, chlorobenzene, dichlorobenzene and the like, and combinations thereof.

Development is typically conducted at a temperature of from 20 to 85°C, for example from 21 to 49°C. Development time with aggressive agitation may be within ten minutes, for example, within five minutes, within two minutes, within one minute, or within 30 seconds. Development may take place, for example, in a static development chamber or in a spray chamber. Typical spray pressures range from 5 to 40 psi, for example, from 10 to 25 psi.

One or more components for improving the flexibility of the structures formed from the composition may be present in the composition. These flexibility-improving materials typically contain a plurality of functional groups chosen from hydroxy, amino, thiol, sulphonate ester, carboxylate ester, silyl ester, anhydride, aziridine, methylolmethyl, silyl ether, epoxides, oxetanes, vinyl ethers, silanols and combinations thereof. In the flexibility-improving materials, the functional groups are typically attached to backbone materials. Exemplary backbone materials include substituted and unsubstituted alkyl and aryl hydrocarbons, ethers, acrylates, novolacs, polyimides, polyurethanes, polyesters, polysulfones, polyketones, fullerenes, POSS silicons, nanoparticles, and combinations thereof. The functional groups may be present as end groups on the backbone and/or at one or more locations along the backbone.

Examples of flexibilizing components are polyols of formula R³(OH)ₓ wherein R³ is an organic group chosen from substituted or unsubstituted (C₂ - C₂₅) alkyl, (C₇ - C₂₅) aryl, (C₈ - C₂₅) aralkyl, (C₆ - C₂₅) cycloalkyl, and combinations thereof, wherein x is 2 or more and does not exceed the number of carbon atoms. When x is 2, examples of the flexibilizing component include glycols, which are 1,2 diols, such as HOCH₂-CHOH-(CH₂)_{y}-CH₃ wherein y may be, for example, from 0 to 22, such as propylene glycol and butylene glycol. Other examples include α,ω-diols such as HO-(CH₂)_{z}-OH wherein z is, for example, from 2 to 25 such as ethylene glycol, 1,3-propanediol and 1,4-butanediol. When x is 3 examples include glycerin and trimethylolpropane.

R³ may also be a polyether of formula -O-(CR⁴₂)_{w}- wherein w is, for example, from 1 to 13 and R⁴ is the same or different and may be, for example, H, or a substituted or unsubstituted organic group of formula C₁ - C₁₂ alkyl, aryl, aralkyl or cycloalkyl. Examples of flexibilizing components include polyether diols of polyethylene oxide, polypropylene oxide, polybutylene oxide, and polytetrahydrofurane.

The flexibility-improving component may have a weight average molecular weight, for example, of from 62 to 5000, for example from 62 to 2000. This component is present in an effective amount to improve the flexibility of the composition in a dried state before and after activation. The specific amount will depend, for example on the backbone and type of and number of functional groups of the flexibility-improving component. This component may, for example, be present in the composition in an amount of from 0.5 to 35wt%, for example from 2 to 20 wt%.

In addition to the foregoing flexibilizers, the use of siloxanes such as those described above with reference to the polymer having units of the formula ((R²)₂SiO) may be used.

Other additives may optionally be present in the compositions including, but are not limited to, surface leveling agents, wetting agents, antifoam agents, adhesion promoters, thixotropic agents, fillers, viscosity modifiers, and the like. Such additives are well known in the art of coating compositions. The use of surface leveling agents, for example silicone-base oils such as SILWET L-7604 silicone-base oil available from Dow Chemical Company, in the compositions may be used. It will be appreciated that more than one additive may be combined in the compositions of the present invention. For example, a wetting agent may be combined with a thixotropic agent. The amounts of such optional additives to be used in the present compositions will depend on the particular additive and desired effect, and are within the ability of those skilled in the art. Such other additives are typically present in the composition in an amount of less than 5 wt%, for example less than 2.5 wt%.

The compositions useful in the invention may optionally contain one or more organic cross-linking agents. Cross-linking agents include, for example, materials which link up components of the composition in a three-dimensional manner. Aromatic or aliphatic cross-linking agents that react with the silicon-containing polymer are suitable for use in the present invention. Such organic cross-linking agents will cure to form a polymerized network with the silicon-containing polymer, and reduce solubility in a developer solution. Such organic cross-linking agents may be monomers or polymers. It will be appreciated by those skilled in the art that combinations of cross-linking agents may be used successfully in the present invention.

Suitable organic cross-linking agents useful in the present invention include, but are not limited to, amine containing compounds, epoxy containing materials, compounds containing at least two vinyl ether groups, allyl substituted aromatic compounds, and combinations thereof. Typical cross-linking agents include amine containing compounds and epoxy containing materials.

The amine containing compounds useful as cross-linking agents in the present invention include, but are not limited to, melamine monomers, melamine polymers, alkylolmethyl melamines, benzoguanamine resins, benzoguanamine-formaldehyde resins, urea-formaldehyde resins, glycoluril-formaldehyde resins, and combinations thereof.

It will be appreciated by those skilled in the art that suitable organic cross-linker concentrations will vary with factors such as cross-linker reactivity and specific application of the composition. When used, the cross-linking agent(s) is typically present in the composition in an amount of from 0.1 to 50 wt%, for example, from 0.5 to 25 wt% or from 1 to 20 wt%.

One or more of the additives may serve to adjust refractive indices of the polymeric layers, for example, in the case of an optical waveguide, the core and/or clad layers.

The composition may further include a solvent. A wide variety of solvents may be used, for example: glycol ethers, such as ethylene glycol monomethyl ether, propylene glycol monomethyl ether, and dipropylene glycol monomethyl ether; esters such as methyl cellosolve acetate, ethyl cellosolve acetate, propylene glycol monomethyl ether acetate, dipropylene glycol monomethyl ether acetate; dibasic esters; carbonates such as propylene carbonate; γ-butyrolactone; esters such as ethyl lactate, n-amyl acetate and n-butyl acetate; alcohols such as n-propanol, iso-propanol; ketones such as cyclohexanone, methyl isobutyl ketone, diisobutyl ketone and 2-heptanone; lactones such as γ-butyrolactone and γ-caprolactone; ethers such as diphenyl ether and anisole; hydrocarbons such as mesitylene, toluene and xylene; and heterocyclic compounds such as N-methyl-2-pyrrolidone, N,N'-dimethylpropyleneurea; and mixtures thereof.

The described compositions are useful for both the dry-film and the directly-applied liquid-coated polymeric layers. In the case of a dry-film, the composition is coated onto the carrier substrate, whereas the compositions are coated directly on the device substrate in the directly-applied layers.

Dry film can be prepared, for example, by coating the described compositions onto a carrier substrate as described above by methods that include, for example, meniscus coating, spray coating, roller coating, wire roll coating, doctor blade coating, curtain coating and the like, typically to a dry thickness of 5 to 150 µm. The coated carrier substrates can be dried, for example, by convection drying, infrared drying, air drying and the like, typically to a solvent content of from 0 to 10 wt%, based on the polymeric layer.

The carrier substrate may, for example, be in the form of discrete sheets, typically from 2 to 150 cm in width and from 2 to 150 cm in length, which may be coated and dried as sheets and stacked. The carrier sheet may further be in the form of a roll, typically from 2 to 150 cm in width and from 0.5 to 1000 meters in length, which may be coated and dried in a reel-to-reel format, commonly known as a web coating process. The sheets may be stacked or the web rolled with or without a protective cover layer as described above, thus separating the sheets or wraps. In the web coating process, the protective cover sheet may be applied by such methods as lamination with or without heat and/or pressure.

The following prophetic examples are intended to illustrate further various aspects of the present invention, but are not intended to limit the scope of the invention in any aspect.

### EXAMPLE 1

### 1. Bottom Clad Layer

45.00 wt% propylene glycol monomethyl ether acetate, 54.84 wt% phenylmethyl-dimethylsilsesquioxane (40:45:15 wt% based on polymer), 0.15 wt% triphenylsulfonium tosylate, and 0.01 wt% Dow SILWET L-7604 silicone-base oil are combined in admixture. The composition is roller coated onto 50 µm polyethylene terephthalate (PET) film to a wet thickness of 100 µm and dried in a convection oven for 30 minutes at 90°C to a thickness of 50 µm. A polyethylene (PE) protective cover sheet of 25 µm thickness is applied to the surface of the composition with a roller to create a waveguide clad dry-film. A 30 mg/cm² copper foil clad printed wiring board which contains circuitry thereon is placed in a hot roll laminator. The PE protective cover sheet is removed from the dry-film. The surface of the dry-film clad coating is placed against the copper surface of the printed wiring board, and the dry-film is laminated to the printed wiring board in the hot-roll laminator at 30 cm/min at 1.4x10⁵ Pa, and at a temperature of 100°C. The coated printed wiring board is blanket exposed to 1500 mJ/cm² of actinic radiation from a mercury halide lamp. The PET film is removed from the structure, and the printed wiring board is placed in a convection oven at 180°C for 60 minutes to cure the bottom clad layer.

### 2. Core Layer

45.00 wt% propylene glycol monomethyl ether acetate, 54.84 wt% phenyl-methyl-dimethylsilsesquioxane (50.5:44.5:5 wt% based on polymer), 0.15 wt% triphenylsulfonium tosylate, and 0.01 wt% Dow S_{ILWET} L-7604 silicone-base oil are combined in admixture. The composition is roller coated onto the bottom clad layer. The core coated printed wiring board is exposed to 1500 mJ/cm² of actinic radiation from a mercury halide lamp through a mask containing openings of from 2 to 30 cm with widths of from 25 to 250 µm. The printed wiring board is placed in a convection oven for 20 minutes at 90°C. The printed wiring board is placed in a 0.7 N NaOH developer solution for 2.5 minutes at room temperature with mild agitation. The printed wiring board is rinsed in DI water and dried with an air knife. The printed wiring board is cured in a convection oven at 180°C for 60 minutes, resulting in a plurality of waveguide cores on a waveguide bottom clad layer.

### 3. Top Clad Layer

The same materials and procedures as described for the bottom clad layer are used to form a top clad layer over the bottom clad layer and core structures, thereby forming a waveguide structure on a printed wiring board substrate.

### EXAMPLE 2

### 1. Bottom Clad Layer

45.00 wt% propylene glycol monomethyl ether acetate, 54.84 wt% phenyl methyl-dimethylsilsesquioxane (42.5:42.5:15 wt% based on polymer), 0.15 wt% triphenylsulfonium tosylate, and 0.01 wt% Dow S_{ILWET} L-7604 silicone-base oil are combined in admixture. The composition is roller coated onto a 30 mg/cm² copper foil clad printed wiring board which contains circuitry thereon. The coated printed wiring board is blanket exposed to 1500 mJ/cm² of actinic radiation from a mercury halide lamp. The board is placed in a convection oven at 180°C for 60 minutes to cure the bottom clad layer.

### 2. Core Layer

45.00 wt% propylene glycol monomethyl ether acetate, 54.84 wt% phenylmethyl-dimethylsilsesquioxane (50.5:44.5:5 wt% based on polymer), 0.15 wt% triphenylsulfonium tosylate, and 0.01 wt% Dow S_{ILWET} L-7604 silicone-base oil are combined in admixture. The composition is roller coated onto 50 µm PET film to a wet thickness of 100 µm and dried in a convection oven for 30 minutes at 90°C to a thickness of 50 µm. A PE protective cover sheet of 25 µm thickness is applied to the surface of the composition with a roller to create a waveguide core dry-film. The printed wiring board laminated with the waveguide clad layer is placed in a hot roll laminator. The PE film is removed from the waveguide core dry-film. The surface of the core dry-film is placed against the waveguide bottom clad layer on the printed wiring board, and the core dry-film is laminated in the hot-roll laminator at 30 cm/min at 1.4x10⁵ Pa, and a temperature of 100°C. The coated printed wiring board is exposed to 1500 mJ/cm² of actinic radiation from a mercury halide lamp through a mask containing openings of from 2 to 30 cm with widths of from 25 to 250 µm. The printed wiring board is placed in a convection oven for 20 minutes at 90°C. The PET is removed and the printed wiring board is placed in a 0.7 N NaOH developer solution for 2.5 minutes at room temperature with mild agitation. The printed wiring board is rinsed in DI water and dried with an air knife. The printed wiring board is cured in a convection oven at 180°C for 60 minutes, resulting in a plurality of waveguide cores on a waveguide bottom clad layer.

### 3. Top Clad Layer

The same materials and procedures as described for the bottom clad layer are used to form a top clad layer over the bottom clad layer and core structures, thereby forming a waveguide structure on a printed wiring board substrate.

### EXAMPLE 3

### 1. Bottom Clad Layer

45.00 wt% propylene glycol monomethyl ether acetate, 54.84 wt% phenyl-methyl-dimethylsilsesquioxane (42.5:42.5:15 wt% based on polymer), 0.15 wt% triphenylsulfonium tosylate, and 0.01 wt% Dow S_{ILWET} L-7604 silicone-base oil are combined in admixture. The composition is roller coated onto a web of 50 µm polyethylene terephthalate (PET) film having a back side release layer to a wet thickness of 100 µm and dried in a convection oven for 30 minutes at 90°C to a thickness of 50 µm. The web is wound into a roll configuration with the back side of the PET acting as a protective cover sheet to create a waveguide clad dry-film. A 30 mg/cm² copper foil clad printed wiring board which contains circuitry thereon is placed in a hot roll laminator. The surface of the dry-film clad coating is placed against the copper surface of the printed wiring board, and the dry-film is laminated to the printed wiring board in the hot-roll laminator at 30 cm/min at 1.4x10⁵ Pa, and at a temperature of 100°C. The coated printed wiring board is blanket exposed to 1500 mJ/cm² of actinic radiation from a mercury halide lamp. The PET film is removed from the structure, and the printed wiring board is placed in a convection oven at 180°C for 60 minutes to cure the bottom clad layer.

### 2. Core Layer

45.00 wt% propylene glycol monomethyl ether acetate, 54.84 wt% phenylmethyl-dimethylsilsesquioxane (50.5:44.5:5 wt% based on polymer), 0.15 wt% triphenylsulfonium tosylate, and 0.01 wt% Dow SILWET L-7604 silicone-base oil are combined in admixture. The composition is roller coated onto a web of 50 µm PET film having a back side release layer to a wet thickness of 100 µm and dried in a convection oven for 30 minutes at 90°C to a thickness of 50 µm. The web is wound into a roll configuration with the back side of the PET acting as a protective cover sheet to create a waveguide core dry-film. The printed wiring board laminated with the waveguide clad layer is placed in a hot roll laminator. The surface of the core dry-film is placed against the waveguide bottom clad layer on the printed wiring board, and the core dry-film is laminated in the hot-roll laminator at 30 cm/min at 1.4x10⁵ Pa, and a temperature of 100°C. The coated printed wiring board is exposed to 1500 mJ/cm² of actinic radiation from a mercury halide lamp through a mask containing openings of from 2 to 30 cm with widths of from 25 to 250 µm. The printed wiring board is placed in a convection oven for 20 minutes at 90°C. The PET is removed and the printed wiring board is placed in a 0.7 N NaOH developer solution for 2.5 minutes at room temperature with mild agitation. The printed wiring board is rinsed in DI water and dried with an air knife. The printed wiring board is cured in a convection oven at 180°C for 60 minutes, resulting in a plurality of waveguide cores on a waveguide bottom clad layer.

### 3. Top Clad Layer

45.00 wt% propylene glycol monomethyl ether acetate, 54.84 wt% phenylmethyl-dimethylsilsesquioxane (42.5:42.5:15 wt% based on polymer), 0.15 wt% triphenylsulfonium tosylate, and 0.01 wt% Dow S_{ILWET} L-7604 silicone-base oil are combined in admixture. The composition is curtain coated onto the core structures on the printed wiring board. The top clad coated printed wiring board is blanket exposed to 1500 mJ/cm² of actinic radiation from a mercury halide lamp. The printed wiring board is cured in a convection oven at 180°C for 60 minutes, resulting in a plurality of waveguide cores on a waveguide bottom clad layer.

### EXAMPLE 4

The same methods used in Example one are employed except that the compositions are roller coated onto a polyethylene coated Kraft paper instead of PET, and the Kraft paper is removed prior to exposure.

While the invention has been described in detail with reference to specific embodiments thereof, it will be apparent to one skilled in the art that various changes and modifications can be made, and equivalents employed, without departing from the scope of the claims.

## Claims

1. A method of forming an optical waveguide (20), comprising:
(a) applying over a first substrate (10) a dry-film (1, 1') comprising: a carrier substrate (2) and a first polymeric layer (4, 12) over the carrier substrate;
(b) forming a second polymeric layer (17) over the first substrate by a method comprising coating over the first substrate a liquid composition (18); and
(c) patterning the first polymeric layer and/or the second polymeric layer, wherein the first polymeric layer and the second polymeric layer each form a core or clad layer of the optical waveguide,
wherein the first and second polymeric layers comprise units of the formula (R¹SiO_{1.5}) and R²SiO_{1.5} respectively,
wherein R¹ is a substituted or unsubstituted organic group, and wherein the liquid composition comprises units of the formula (R²SiO_{1.5}), wherein R² is a substituted or unsubstituted organic group, and R¹ and R² are the same or different.

2. The method of claim 1, further comprising forming a third polymeric layer (4, 12) over the first substrate, the third polymeric layer comprising units of the formula (R³SiO_{1.5}), wherein R³ is a substituted or unsubstituted organic group and is the same as or different from R¹ and/or R².

3. The method of any of claims 1-2, wherein the first polymeric layer and/or the second polymeric layer is photoimageable, and wherein (c) comprises exposing a portion of the first polymeric layer and/or the second polymeric layer to actinic radiation (14).

4. The method of claim 3, wherein (c) further comprises contacting the exposed first polymeric layer and/or the second polymeric layer with a developer solution.

5. The method of any of claims 1-4, wherein the second polymeric layer is disposed over the first polymeric layer.

6. The method of any of claims 1-4, wherein the first polymeric layer is disposed over the second polymeric layer.

7. The method of any of claims 1-6, further comprising after (a), removing the carrier substrate.

8. The method of any of claims 1-7, wherein the carrier substrate is a polymeric film.

9. The method of claim 1, wherein the first substrate is a printed wiring board substrate (10), the method comprising:
(a) providing a waveguide first clad layer over a printed wiring board substrate, wherein the first clad layer comprises units of the formula (R¹SiO_{1.5}), wherein R¹ is a substituted or unsubstituted organic group;
(b) applying over the first clad layer a dry-film comprising: a carrier substrate and a waveguide core layer over the carrier substrate, the core layer comprising units of the formula (k²SiO_{1.5}), wherein R² is a substituted or unsubstituted organic group, and wherein R¹ and R² are the same or different;
(c) patterning the core layer to form a core structure; and
(d) forming a waveguide second clad layer over the first clad layer and the core structure by a method comprising coating over the first clad layer and the core structure a liquid polymer comprising units of the formula (R³SiO_{1.5}), wherein R³ is a substituted or unsubstituted organic group and is the same as or different from R¹ and/or R².

## Patentansprüche

1. Verfahren zur Herstellung eines Lichtwellenleiters (20), umfassend:
(a) Aufbringen einer Trockenfolie (1, 1'), umfassend
ein Trägersubstrat (2) und eine erste polymere Schicht (4, 12) über dem Trägersubstrat,
über einem ersten Substrat (10),
(b) Erzeugen einer zweiten polymeren Schicht (17) über dem ersten Substrat durch ein Verfahren, umfassend das Beschichten des ersten Substrats mit einer flüssigen Zusammensetzung (18), und
(c) das Strukturieren der ersten polymeren Schicht und/oder der zweiten polymeren Schicht,
wobei die erste polymere Schicht und die zweite polymere Schicht jeweils eine Kern- oder Ummantelungsschicht des Lichtwellenleiters bilden,
wobei die erste und zweite polymere Schicht Einheiten der Formel (R¹SiO_{1.5}) beziehungsweise (R²SiO_{1.5}) umfassen, wobei R¹ eine substituierte oder unsubstituierte organische Gruppe ist, und wobei die flüssige Zusammensetzung Einheiten der Formel (R²SiO_{1.5}) umfaßt, wobei R² eine substituierte oder unsubstituierte organische Gruppe ist, und R¹ und R² gleich oder verschieden sind.

2. Verfahren nach Anspruch 1, weiter das Erzeugen einer dritten polymeren Schicht (4, 12) über dem ersten Substrat umfassend, wobei die dritte polymere Schicht Einheiten der Formel (R³SiO_{1.5}) umfaßt, wobei R³ eine substituierte oder unsubstituierte organische Gruppe ist und gleich zu oder verschieden von R¹ und/oder R² ist.

3. Verfahren nach einem der Ansprüche 1 bis 2, wobei die erste polymere Schicht und/oder die zweite polymere Schicht photoabbildbar ist, und wobei (c) das Aussetzen eines Teils der ersten polymeren Schicht und/oder der zweiten polymeren Schicht gegenüber photochemischer Strahlung (14) umfaßt.

4. Verfahren nach Anspruch 3, wobei (c) weiter das Inkontaktbringen der strahlenexponierten ersten polymeren Schicht und/oder zweiten polymeren Schicht mit einer Entwicklerlösung umfaßt.

5. Verfahren nach einem der Ansprüche 1 bis 4, wobei die zweite polymere Schicht über der ersten polymeren Schicht abgelagert ist.

6. Verfahren nach einem der Ansprüche 1 bis 4, wobei die erste polymere Schicht über der zweiten polymeren Schicht abgelagert ist.

7. Verfahren nach einem der Ansprüche 1 bis 6, weiter umfassend das Entfernen des Trägersubstrats nach (a).

8. Verfahren nach einem der Ansprüche 1 bis 7, wobei das Trägersubstrat eine polymere Folie ist.

9. Verfahren nach Anspruch 1, wobei das erste Substrat eine gedruckte Platine (10) ist, wobei das Verfahren umfasst:
(a) Bereitstellen einer ersten Lichtwellenleiterummantelungsschicht über einer gedruckten Platine, wobei die erste Ummantelungsschicht Einheiten der Formel (R¹SiO_{1.5}) umfaßt, wobei R¹ eine substituierte oder unsubstituierte organische Gruppe ist,
(b) Aufbringen einer Trockenfolie, umfassend ein Trägersubstrat und eine Lichtwellenleiterkernschicht über dem Trägersubstrat, wobei die Kernschicht Einheiten der Formel (R²SiO_{1.5}) umfaßt, wobei R² eine substituierte oder unsubstituierte organische Gruppe ist, und wobei R¹ und R² gleich oder verschieden sind, über der ersten Ummantelungsschicht,
(c) Strukturieren der Kernschicht um eine Kernstruktur zu bilden, und
(d) Erzeugen einer zweiten Lichtwellenleiterummantelungsschicht über der ersten Ummantelungsschicht und der Kernstruktur durch ein Verfahren, welches das Beschichten mit einem flüssigen Polymer, das Einheiten der Formel (R³SiO_{1.5}) umfaßt, wobei R³ eine substituierte oder unsubstituierte organische Gruppe ist, und gleich zu oder verschieden von R¹ und/oder R² ist, über der ersten Ummantelungsschicht und der Kernstruktur, umfaßt.

## Revendications

1. Procédé de formation d'un guide d'ondes optiques (20), comprenant :
(a) l'application sur un premier substrat (10) d'un film sec (1, 1') comprenant : un substrat de support (2) et une première couche polymère (4, 12) sur le substrat de support ;
(b) la formation d'une seconde couche polymère (17) sur le premier substrat par un procédé comprenant l'application en revêtement sur le premier substrat d'une composition liquide (18) ; et
(c) la formation d'un motif dans la première couche polymère et/ ou la seconde couche polymère,
où la première couche polymère et la seconde couche polymère forment chacune une couche de coeur ou de gaine du guide d'ondes optiques,
où les première et seconde couches polymères comprennent des unités de formule (R¹SiO₁,₅) et R²SiO_{1,5} respectivement,
où R¹ est un groupe organique substitué ou non substitué, et où la composition liquide comprend des unités de formule (R²SiO_{1,5}) où R² est un groupe organique substitué ou non substitué, et R¹ et R² sont identiques ou différents.

2. Procédé selon la revendication 1 comprenant en outre la formation d'une troisième couche polymère (4, 12) sur le premier substrat, la troisième couche polymère comprenant des unités de formule (R³SiO_{1,5}) où R³ est un groupe organique substitué ou non substitué et est identique ou différent de R¹ et/ou R².

3. Procédé selon l'une quelconque des revendications 1-2 où la première couche polymère et/ou la seconde couche polymère est ou sont susceptible(s) de photo-imagerie, et où (c) comprend l'exposition d'une partie de la première couche polymère et/ou de la seconde couche polymère à un rayonnement actinique (14).

4. Procédé selon la revendication 3 où (c) comprend en outre la mise en contact de la première couche polymère exposée et/ou de la seconde couche polymère exposée avec une solution de développateur.

5. Procédé selon l'une quelconque des revendications 1-4 où la seconde couche polymère est disposée sur la première couche polymère.

6. Procédé selon l'une quelconque des revendications 1-4 où la première couche polymère est disposée sur la seconde couche polymère.

7. Procédé selon l'une quelconque des revendications 1-6 comprenant en outre après (a) le retrait du substrat de support.

8. Procédé selon l'une quelconque des revendications 1-7 où le substrat de support est un film polymère.

9. Procédé selon la revendication 1 où le premier substrat est un substrat de circuit imprimé (10), le procédé comprenant :
(a) la fourniture d'une première couche de gaine de guide d'ondes sur un substrat de circuit imprimé, où la première couche de gaine comprend des unités de formule (R¹SiO_{1,5}) où R¹ est un groupe organique substitué ou non substitué ;
(b) l'application sur la première couche de gaine d'un film sec comprenant : un substrat de support et une couche de coeur de guide d'ondes sur le substrat de support, la couche de coeur comprenant des unités de formule (R²SiO_{1,5}) où R² est un groupe organique substitué ou non substitué, et où R¹ et R² sont identiques ou différents ;
(c) la formation d'un motif dans la couche de coeur pour former une structure de coeur ; et
(d) la formation d'une seconde couche de gaine de guide d'ondes sur la première couche de gaine et la structure de coeur par un procédé comprenant l'application en revêtement sur la première couche de gaine et la structure de coeur d'un polymère liquide comprenant des unités de formule (R³SiO_{1,5}) où R³ est un groupe organique substitué ou non substitué et est identique ou différent de R¹ et/ou R².
